Europäisches Patentamt

European Patent Office

Office européen des brevets

(19)

(11) Veröffentlichungsnummer: **0 189 205**

**A1**

(12) **EUROPÄISCHE PATENTANMELDUNG**

(21) Anmeldenummer: 86100932.2

(22) Anmeldetag: 24.01.86

(51) Int. Cl.⁴: **H03K 17/22** , H02H 3/24

(30) Priorität: 28.01.85 DE 3502750

(43) Veröffentlichungstag der Anmeldung:
30.07.86 Patentblatt 86/31

(84) Benannte Vertragsstaaten:
CH DE FR GB IT LI NL SE

(71) Anmelder: **Siemens Aktiengesellschaft**
**Berlin und München Wittelsbacherplatz 2**
**D-8000 München 2(DE)**

(72) Erfinder: **Obergfell, Rainer, Dipl.-Ing.**
**Langbehnstrasse 11a**
**D-8000 München 21(DE)**

(54) Schutzschaltung für Leistungshalbleiter ansteuernde integrierte Schaltungen.

(57) Die Erfindung betrifft eine Schutzschaltung für eine, einen Leistungshalbleiter LH ansteuernde Treiberschaltung T, die zwischen eine positive und eine negative Betriebsspannung UB geschaltet ist, und die mindestens einen Eingang UE aufweist, der zu positiven und/oder negativen Betriebsspannung eine Spannungsdifferenz aufweist. Erfindungsgemäß ist eine zwischen die positive und die negative Betriebsspannung geschaltete Reihenschaltung aus einer Zenerdiode und einem Strombegrenzungswiderstand RV vorgesehen, wobei über die Zenerdiode Z die Spannungsdifferenz auf einen konstanten Wert einstellbar ist.

EP 0 189 205 A1

Schutzschaltung für Leistungshalbleiter ansteuernde integrierte Schaltungen

Die Erfindung betrifft eine Schutzschaltung gemäß dem Oberbegriff des Patentanspruchs 1.

Bei Endgeräten der Kommunikationstechnik werden oftmals Haupt- und Nebengeräte kombiniert. Das Hauptgerät kann ein Fernschreiber und das Nebengerät ein Lochstreifendrucker sein. Hierbei ist es üblich, Spannungen aus der Stromversorgung des Hauptgerätes zum Nebengerät durchzuschalten und dort zur Stromversorgung von integrierten Schaltungen und ähnlichen Bauteilen zu verwenden. Daneben besitzt das Nebengerät eine eigene Stromversorgung für die dort eingebauten Leistungshalbleiter. Die Leistungshalbleiter werden oftmals über Treiberschaltungen, die durch integrierte Schaltungen realisiert sind, angesteuert. Im Nebengerät sind also die Treiberschaltungen an die Stromversorgung des Hauptgerätes angeschaltet und die Leistungshalbleiter an eine eigene Stromversorgung des Nebengerätes. Wenn die Betriebsspannung für die Treiberschaltungen beispielsweise durch Abschalten der Netzspannung des Hauptgerätes absinkt, können an den Treiberschaltungen unzulässige Betriebszustände auftreten und dadurch die Leistungshalbleiter zerstört werden.

Als Voraussetzung für definierte Zustände an den Ausgängen von integrierten Schaltungen wird in den Datenblättern verlangt, daß mindestens ein Eingang der integrierten Schaltung auf einer Spannung liegt, die um einen bestimmten Betrag kleiner als die positive Betriebsspannung bzw. größer als die negative Betriebsspannung ist. In der Praxis sind Werte von 1 bis 3 Volt erforderlich. Je nach Technologie der integrierten Schaltung kann diese Forderung auf den unteren oder oberen Bereich der Betriebsspannung beschränkt sein. Es ist allgemein bekannt, die Spannungsdifferenz zwischen diesen Eingängen und der Betriebsspannung durch einen Spannungsteiler zu realisieren. Hierbei ist beispielsweise der Eingang mit einem Widerstand mit der Betriebsspannung und mit einem weiteren Widerstand mit einem Bezugspotential verbunden. Bei dieser Schaltung kann die nötige Spannungsdifferenz zwischen dem Eingang und der Betriebsspannung bei einer Änderung der Betriebsspannung in der Regel nicht eingehalten werden, da mit dem Absinken der Betriebsspannung auch ein Absinken der Spannungsdifferenz verbunden ist.

Um ein ordnungsgemäßes Funktionieren der integrierten Schaltung sicherzustellen, darf der Wert der Betriebsspannung einen Mindestwert nicht unterschreiten. Dieser Mindestwert liegt in der Größenordnung von einigen Volt. Wenn die integrierte Schaltung an eine positive und eine negative Betriebsspannung angeschaltet ist, so ist für jede dieser Spannungen ein Mindestwert einzuhalten. Die Spannungsdifferenz zwischen dem Minimalwert der positiven Betriebsspannung und dem Maximalwert der negativen Betriebsspannung muß nicht symmetrisch zur Nulllinie liegen, sondern kann irgendwo im zulässigen Betriebsspannungsbereich zwischen der positiven und der negativen Betriebsspannung liegen.

Werden diese Bedingungen, Spannungsabstand zwischen einem oder mehreren Eingängen der integrierten Schaltung und der postiven und/oder negativen Betriebsspannung, sowie der Mindestwert für die positive und/oder negative Betriebsspannung nicht eingehalten, so kann die Ausgangsspannung der integrierten Schaltung beliebige Werte innerhalb der Betriebsspannungsgrenzen annehmen, wobei auch Schwingungen auftreten können.

Wenn mit der integrierten Schaltung Leistungshalbleiter angesteuert werden, so können diese Effekte zur Zerstörung der Leistungshalbleiter führen, insbesondere dann, wenn die Restenergie der Betriebsspannung noch genügend groß ist. Da die Betriebsspannung für die Leistungshalbleiter nicht mit der Betriebsspannung für die integrierten Schaltungen identisch sein muß, ist die Gefahr der Zerstörung der Leistungshalbleiter bei einer Kombination von Haupt- und Nebengeräten groß.

In Geräten der Kommunikationstechnik wird oftmals ein Fehlersignal, ein sogenanntes "Powerfail"-Signal erzeugt, wenn die Betriebsspannung den zulässigen Bereich beim Abschalten bzw. beim Ausfall der Netzspannung verläßt. Dieses Signal wird in der Regel zur Datensicherung benutzt. Es bietet jedoch keinen hinreichenden Schutz für die Leistungshalbleiter, da es üblicherweise mit Hilfe von integrierten Schaltungen erzeugt wird und die gleichen Fehlfunktionen zeigen kann, wie die integrierten Schaltungen für die Ansteuerung der Leistungshalbleiter.

Der Erfindung liegt die Aufgabe zugrunde, eine Schutzschaltung für von integrierten Schaltungen angesteuerte Leistungshalbleiter anzugeben, die bei Betriebsspannungsschwankungen eine definierte Spannung für den Steuereingang des Leistungshalbleiters sicherstellt.

Diese Aufgabe wird erfindungsgemäß durch die im Patentanspruch 1 angegebenen Merkmale gelöst.

Die erfindungsgemäße Schutzschaltung ist vorteilhaft, wenn die integrierte Schaltung als Treiberschaltung für Leistungshalbleiter verwendet wird.

Über die Zenerdiode ist eine Spannung an einem Eingang der Treiberschaltung einstellbar. Diese Spannung kann in vorteilhafter Weise so gewählt sein, daß beim Absinken der Betriebsspannung unter einen Mindestwert der Leistungshalbleiter gesperrt wird.

Es ist weiter vorteilhaft, wenn über einen Spannungsteiler der Steuereingang des Leistungshalbleiters bei einer minimal zulässigen Betriebsspannung auf einen derartigen Wert eingestellt ist, der sicher ein Durchschalten des Leistungshalbleiters verhindert.

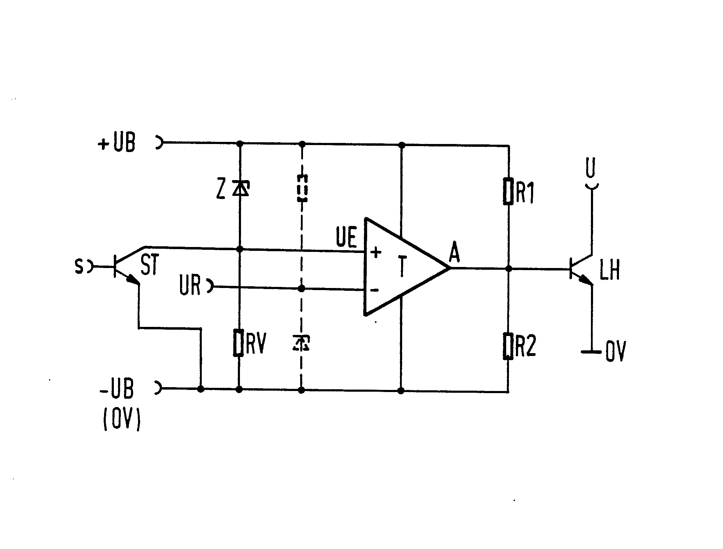

Im folgenden wird die Erfindung anhand eines in der Zeichnung dargestellten Ausführungsbeispieles erläutert.

In der Figur sind eine Treiberschaltung T und ein Leistungshalbleiter LH dargestellt. Die Treiberschaltung T ist durch eine integrierte Schaltung, d.h. durch einen Operationsverstärker realisiert. Der Leistungshalbleiter LH kann ein bipolarer oder ein unipolarer Leistungstransistor, sowie ein Thyristor oder ähnliches sein.

Die Treiberschaltung T ist an einer positiven Betriebsspannung UB+ und an einer negativen Betriebsspannung UB- angeschaltet. Die negative Betriebsspannung UB- kann beispielsweise auch ein Bezugspotential O V sein.

Zwischen die positive und negative Betriebsspannung UB+, UB- ist die Reihenschaltung aus einer Zenerdiode Z und einem Strombegrenzungswiderstand RV geschaltet, wobei die Anode der Zenerdiode Z mit einem nichtinvertierenden Eingang der Treiberschaltung T verbunden ist. An einem invertierenden Eingang der Treiberschaltung T liegt eine Referenzspannung UR an. Über die Zenerdiode Z ist die Spannungsdifferenz zwischen dem nichtinvertierenden Eingang der Treibschaltung T und der positiven Betriebsspannung UB+ auf einen vorgegebenen Wert einstellbar. Diese Spannungsdifferenz wird auch bei Spannungsschwankungen der positiven Betriebsspannung UB+ eingehalten.

Gestrichelt ist in der Figur der Fall noch eingezeichnet, bei dem zwischen dem invertierenden Eingang der Treiberschaltung T und der negativen Betriebsspannung UB- eine Spannungsdifferenz eingehalten wird. Hierzu ist zwischen die positive und negative Betriebsspannung UB +, UB- die Reihenschaltung aus einem Strombegrenzungswiderstand und einer Zenerdiode geschaltet. Die Katode der Zenerdiode ist mit dem invertierenden Eingang der Treiberschaltung T verbunden. Die gestrichelt eingezeichneten Bauteile tragen keine Bezugszeichen. Weiter ist auch nicht eingezeichnet, daß in diesem Fall die Referenzspannung am nichtinvertierenden Eingang der Treiberschaltung T anliegt.

Die Zenerdiode Z ist so gewählt, daß der Spannungsabfall an ihr größer oder gleich ist dem im jeweiligen Datenblatt geforderten Worst-Case-Abstand. Durch den Strombegrenzungswiderstand RV ist der Strom durch die Zenerdiode Z begrenzt. Dem invertierenden Eingang und dem nichtinvertierenden Eingang können in der Fig. nicht dargetellte Widerstände zur Impedanzanpassung vorgeschaltet sein.

Am nichtinvertierenden mit der Zenerdiode Z beschalteten Eingang der Treiberschaltung T - analog gilt dies auch für den invertierenden Eingang der Treiberschaltung T, wenn dieser mit einer Zenerdiode beschaltet ist - können beliebige Steuersignale angelegt werden, solange die erforderliche minimale Spannungsdifferenz zwischen einer am nichtinvertierenden Eingang der Treiberschaltung T abgreifbaren Spannung UE und der positiven Betriebsspannung UB + eingehalten wird.

Die Steuersignale können beispielsweise dadurch erzeugt werden, daß der nichtinvertierende Eingang der Treiberschaltung T über einen steuerbaren Widerstand mit der negativen Betriebsspannung UB- verbunden ist. Der steuerbare Widerstand ist beispielsweise durch die Kollektor-Emitter-Strecke eines Steuertransistors ST realisiert. Die Basis des Steuertransistors ST ist mit einer Schaltklemme S verbunden, an der die externen Steuersignale anliegen.

Bei der Beschaltung eines Einganges der Treiberstufe T mit der Zenerdiode Z und dem Vorwiderstand RV können bei entsprechender Wahl der Zenerspannung der Zenerdiode Z und der Referenzspannung UR die Mindestwerte der positiven und/oder negativen Betriebsspannung UB +, UB- in weiten Grenzen gewählt werden.

Die Spannungsdifferenz zwischen der positiven Betriebsspannung UB + und der am nichtinvertierenden Eingang der Treiberschaltung T abgreifbaren Spannung UE ist über die Zenerdiode Z auf einen vorgegebenen Wert einstellbar. Dieser Wert kann so gewählt sein, daß beim Absinken der positiven Betriebsspannung UB + unter einen Mindestwert die Spannung UE unter die Referenzspannung UR sinkt. Auf diese Weise ist sichergestellt, daß bei einem nicht zulässigen Wert der positiven Betriebsspannung UB + über die Treiberschaltung T der Leistungshalbleiter LH gesperrt wird. Analoges gilt für die negative Betriebsspannung UB-.

Bei der weiteren Beschreibung der in der Fig. dargestellten Schaltungsanordnung wird davon ausgegangen, daß die Treiberschaltung T zwischen die positive Betriebsspannung UB + und das Bezugspotential 0 V geschaltet, und im Ausgangskreis einen Transistor mit offenem Kollektor besitzt. Ein Ausgang A der Treiberschaltung T ist also gegen das Bezugspotential 0 V schaltbar.

Der Ausgang A der Treiberschaltung T, an dem der nicht näher bezeichnete Steuereingang des Leistungshalbleiters LH angeschaltet ist, ist über einen ersten Widerstand R1 mit der positiven Betriebsspannung UB + und über einen zweiten Widerstand R2 mit dem Bezugspotential 0 V verbunden. Der Leistungshalbleiter LH ist zwischen eine Versorgungsspannung U und das Bezugspotential 0 V geschaltet.

Hierbei wird beispielsweise die positive Betriebsspannung UB + für die Treiberschaltung T von einem Hauptgerät, und die Versorgungsspannung U für den Leistungshalbleiter LH von einem Nebengerät geliefert. Die Bezugspotentiale 0 V beider Geräte sind zusammengeschaltet.

Der erste Widerstand R1 wird auch als Pull-up--Widerstand bezeichnet, da er, wenn der Ausgangstransistor der Treiberschaltung T den Ausgang A nicht gegen das Bezugspotential 0 V schaltet, den Steuereingng des Leistungshalbleiters LH auf einen höheren Spannungswert zieht. Hierdurch wird der Leistungshalbleiter LH leitend - schaltet.

Bei einem Absinken der positiven Betriebsspannung UB + unter einen minimal zulässigen Wert wird die Treiberschaltung T funktionsunfähig, d.h. die am Ausgang A abgreifbare Spannung kann beliebige Werte annehmen. Dieser minimal zulässige Wert liegt noch unter dem zuvor erwähnten Mindestwert, bei dem über die Teiberschaltung T der Leistungshalbleiter noch sperrbar ist.

Über den ersten und den zweiten Widerstand R1, R2 wird in diesem Fall die Spannung am Ausgang A auf einen derartigen Wert eingestellt, der nicht mehr ausreicht, den nachgeschalteten Leistungshalbleiter LH leitend zu schalten. Für eine positive Betriebsspannung UB +, die einen Wert angenommen hat, der gleich ist dem minimal zulässigen Wert, wird also über die Widerstände R1, R2 die Spannung am Steuereingang des Leistungshalbleiters LH auf einen Wert eingestellt, der diesen im gesperrten Zustand hält. Bei Transistoren, deren Sperrschichttemperatur 100 ° Celsius nicht überschreitet, genügt hierfür ein Spannungswert der kleiner 0,3 V ist.

Bezugszeichenliste

## Ansprüche

1. Schutzschaltung für einen Leistungshalbleiter (LH) der von einem Ausgang (A) einer Treiberschaltung (T), angesteuert wird, wobei die Treiberschaltung (T) zwischen eine positive und eine negative Betriebsspannung (UB+, UB-) geschaltet ist, und mindestens einen Eingang aufweist, der zur positiven und/oder negativen Betriebsspannung (UB+, UB-) eine Spannungsdifferenz aufweist,

**gekennzeichnet durch**

eine zwischen jeden Eingang und die positive und/oder negative Betriebsspannung (UB+, UB-) geschaltete Schalteinrichtung zur Einstellung der Spannungsdifferenz auf einen konstanten Wert.

2. Schutzschaltung nach Anspruch 1,

**dadurch gekennzeichnet,**

daß die Schalteinrichtung eine Zenerdiode (Z) aufweist.

3. Schutzschaltung nach Anspruch 2,

**gekennzeichnet durch**

einen der Zenerdiode (Z) nachgeschalteten Strombegrenzungswiderstand (RV).

4. Schutzschaltung nach einem der Ansprüche 1 bis 3, **gekennzeichnet durch**

einen zwischen die positive und die negative Betriebsspannung (UB+, UB-) geschalteten ohmschen Spannungsteiler, dessen Spannungsteilerpunkt mit dem Ausgang A verbunden ist, wobei bei einer minimal zulässigen Spannungsdifferenz zwischen der positiven und der negativen Betriebsspannung (UB+, UB-) der Ausgang (A) über die Widerstände (R1, R2) auf einen so niedrigen Spannungswert eingestellt wird, daß eine Leitendschaltung des Leistungshalbleiters (LH) unterbunden ist.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | US-A-4 439 805 (TARLETON) * Figuren; Seite 2, Zeile 9 - Spalte 4, Zeile 12 * | 1-3 | H 03 K 17/22 H 02 H 3/24 |
| | --- | | |
| Y | EP-A-0 080 874 (FUJITSU) * Figur 2; Zusammenfassung; Seite 4, Zeile 21 - Seite 5, Zeile 14 * | 1-3 | |
| | --- | | |
| A | PATENTS ABSTRACTS OF JAPAN, Band 8, Nr. 49 (E-230) [1486], 6. März 1984, Seite 151 E 230; & JP - A - 58 204 620 (NIPPON DENKI K.K.) 29.11.1983 | 1-4 | |
| | ----- | | |

**RECHERCHIERTE SACHGEBIETE (Int. Cl.4)**

H 03 K
H 02 H

Der vorliegende Recherchenbericht wurde für alle Patentansprüche erstellt.

| Recherchenort DEN HAAG | Abschlußdatum der Recherche 11-04-1986 | Prüfer KOLBE W.H. |
|---|---|---|